# FASCICULE DE BREVET EUROPEEN

(11) **EP 0 526 266 B1**
(45) Date de publication et mention de la délivrance du brevet: **29.06.1994**
(21) Numéro de dépôt: 92401705.6
(22) Date de dépôt: 18.06.1992
(51) Int. Cl.: H01S 3/19, H01L 33/00, H01L 21/20, H01L 31/00

(54) **Procédé de réalisation d'un dispositif optoélectronique**
Herstellungsverfahren für eine optoelektronische Vorrichtung
Method of manufacturing an optoelectronic device

(30) Priorité: 05.07.1991 FR 9108452
(43) Date de publication de la demande: 03.02.1993
(73) Titulaire: THOMSON-CSF, 75008 Paris (FR)
(72) Inventeur: Hirtz, Jean-Pierre, F-92045 Paris la Défense (FR); Garcia, Jean-Charles, F-92045 Paris la Défense (FR); Maurel, Philippe, F-92045 Paris la Défense (FR)
(74) Mandataire: Guérin, Michel

(56) Documents cités:
- APPLIED PHYSICS LETTERS. vol. 56, no. 11, 12 Mars 1990, NEW YORK US,pages 1014-1016; H.P.LEE et.al: 'Double-heterostructure GaAs/AlGaAs lasers on Si substrates with reduced threshold current and built-in index guiding by selective area molecular beam epitaxy'
- APPLIED PHYSICS LETTERS, vol. 31, no. 4, 15 Août 1977, NEW YORK US,pages 301-304; W.T.TSANG et.al.:'Selective area growth of GaAs/AlGaAs multilayer strucutures with molecular beam epitaxy using Si shadow masks'

## Description

L'invention concerne un procédé de réalisation d'un dispositif optoélectronique tel qu'une diode laser ou un photodétecteur et plus particulièrement un dispositif en forme "de ruban" ("ridge" en terminologie anglo-saxonne).

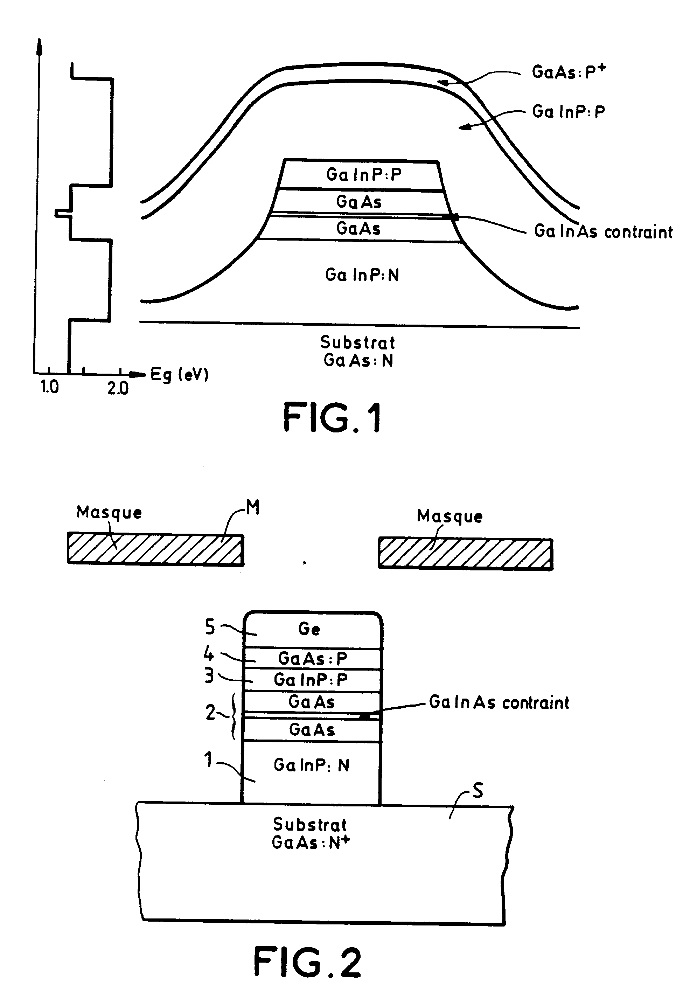

Les procédés généralement utilisés pour la réalisation de diodes et de réseaux de diodes laser, souffrent d'une technologie "lourde" comportant un nombre élevé d'étapes élémentaires. Par exemple, la structure "ridge" couramment utilisée et schématisée figure 1 nécessite :
- 2 étapes d'épitaxie
- 1 étape lithographie/gravure
- 1 implantation ionique ou protonique

Les techniques d'épitaxie en ultra-vide du type Epitaxie par jets moléculaires (MBE) ou jets chimiques (CBE) ouvrent des possibilités nouvelles en termes d'épitaxie sélective. La nature moléculaire des flux en MBE et CBE offre la possibilité d'une croissance sélective à travers un masque mécanique placé sur le substrat. Par ailleurs, seules ces techniques permettent la croissance de matériaux III-V semi-isolant, comme par exemple GaAlAs, InP ou GaInP.

Par exemple, l'article de W.T. TSANG et al "Selective area growth of GaAs/AlₓGa₁₋ₓAs multilayer structures with molecular beam epitaxy using Si shadow masks" publié dans Applied Physics Letters, Vol 31, n° 4, August 15, 1977, décrit une méthode d'épitaxie à travers un masque mécanique. Cependant aucun procédé de fabrication de dispositifs optoélectroniques n'utilise cette technique pourtant connue.

L'invention concerne un procédé de réalisation de dispositif optoélectronique du type "ridge" comportant un nombre réduit d'étapes de réalisation. Notamment, ce procédé présente l'avantage de ne nécessiter qu'une seule étape d'épitaxie pour la croissance du ruban.

L'invention concerne donc un procédé de réalisation d'un dispositif optoélectronique comportant les étapes suivantes :
- une étape de mise en place, dans une enceinte d'épitaxie, d'un masque au-dessus d'un substrat à épitaxier ;
- une première étape d'épitaxie, sur le substrat, à travers le masque, de différentes couches constitutives du dispositif optoélectronique :
   . première couche de confinement optique
   . couches actives
   . deuxième couche de confinement optique
   . couche de contact
   . couche de masquage
- une étape de retrait du masque sans ouverture de l'enceinte d'épitaxie ;
- une deuxième étape d'épitaxie d'une couche de confinement optique et électrique ;
- une étape de retrait de la couche de masquage et du matériau de la couche de confinement optique et électrique révélant la couche de contact.

Les différents objets et caractéristiques de l'invention apparaîtront plus clairement dans la description qui va suivre faite à titre d'exemple et dans les figures annexées qui représentent :
- la figure 1, un dispositif en forme de "ridge" connu dans la technique et décrit précédemment ;
- les figures 2, 3 et 4, différentes étapes de réalisation du procédé de l'invention.

En se reportant aux figures 2 à 4, on va donc décrire un procédé de réalisation selon l'invention.

Un substrat S étant disposé dans un bâti d'épitaxie, on place au-dessus de la face du substrat S à épitaxier, un masque M. Ce masque est proche ou attenant au substrat. On réalise ensuite l'épitaxie des différentes couches successives du composant à obtenir à travers le même masque M (figure 2). Par exemple un composant optoélectronique du type laser sera obtenu par l'épitaxie :
- d'une première couche de confinement 1 ;
- d'une ou de plusieurs couches actives du laser 2 ;
- d'une deuxième couche de confinement 3 ;
- d'une couche de contact 4 ;
- d'une couche de masquage 5.

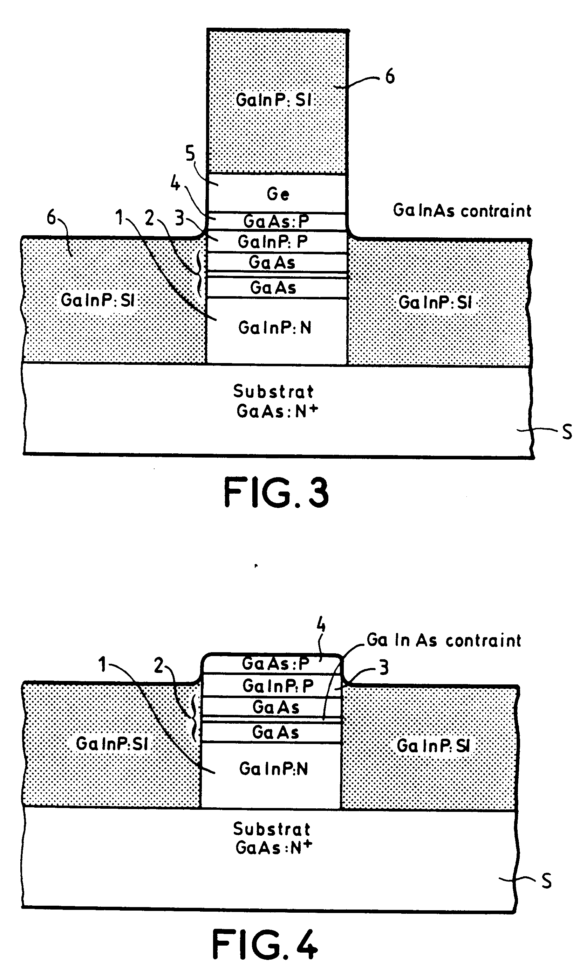

Le masque mécanique M est ensuite retiré de la surface du substrat sans pour autant ouvrir le bâti d'épitaxie. Ensuite, une couche 6 d'un matériau de confinement est épitaxié comme cela est représenté en figure 3.

Cette couche 6 recouvre le substrat S de part et d'autre de la structure 1,2,3,4,5 de façon à confiner optiquement et électriquement au moins latéralement la couche active 2. La couche 6 recouvre également la partie supérieure de la couche 5.

Enfin comme cela est représenté en figure 4, la couche 6 est gravée lors de la gravure sélective de la couche 5.

L'épitaxie à travers le masque M des couches 1 à 5 peut se faire par toute méthode de croissance utilisant des jets moléculaires telle que la MBE (épitaxie par jet moléculaire EJM) ou la CBE (épitaxie par jet chimique EJC). L'épitaxie de la couche 6 peut se faire par le même procédé. De cette façon le dispositif peut être réalisé par épitaxie in-situ, c'est-à-dire sans sortir le dispositif en cours de procédé, ni ouvrir le bâti d'épitaxie.

Ce procédé d'élaboration de barrettes laser permet en une étape technologique (croissance MBE ou CBE), la réalisation de laser et de barrettes de laser à base d'hétérostructures de matériaux III-V, comme par exemple GaAlAs/GaAs (0.7-0.9 »m), GaInAsP/InP (1.2-1.5 »m), GaInP/GaInAs (0.9- 1.1 »m).

A titre indicatif, ce procédé peut être mis en oeuvre en prévoyant une distance cellules, d'évaporation-substrat de 12 cm par exemple (5 à 20 cm) et une distance masque-substrat de 1 mm (environ de 0 mm à 2 mm). Avec une distance masque-substrat de 1 mm, on génère des effets de bords sur typiquement 40 mm de largeur dans une configuration de jet moléculaire perpendiculaire à la surface du masque ce qui est acceptable pour un dispositif de largeur de 1 »m par exemple.

Il est bien évident que la description qui précède n'a été donnée qu'à titre d'exemple. D'autres variantes peuvent être envisagées sans sortir du cadre de l'invention. Les exemples numériques et de matériaux n'ont été donnés que pour illustrer la description. L'essentiel de l'invention réside dans le fait que la structure est réalisée entièrement dans l'environnement ultra-vide du système d'épitaxie sans exposition à l'air des structures et sans opération de gravure intermédiaire ni d'implantation ionique.

L'invention est plus particulièrement applicable à la réalisation d'un laser du type B.R.S (Buried Ridge Structure) c'est-à-dire d'un laser enterré à structure en ruban ou à la réalisation de réseaux de lasers. La couche active 2 peut être réalisée au cours de la même étape d'épitaxie sous la forme d'un empilement de couches constituant, comme cela est représenté sur les figures 2 à 4, un puits quantique.

## Revendications

1. Procédé de réalisation d'un dispositif optoélectronique comportant les étapes suivantes :
- une étape de mise en place, dans une enceinte d'épitaxie, d'un masque (M) au-dessus d'un substrat (S) à épitaxier ;
- une première étape d'épitaxie, sur le substrat (S), à travers le masque, de différentes couches constitutives du dispositif optoélectronique :
. première couche de confinement optique (1)
. couches actives (2)
. deuxième couche de confinement optique (3)
. couche de contact (4)
. couche de masquage (5)
- une étape de retrait du masque (M) sans ouverture de l'enceinte d'épitaxie ;
- une deuxième étape d'épitaxie d'une couche de confinement optique et électrique (6) ;
- une étape de retrait de la couche de masquage (5) et du matériau de la couche de confinement optique et électrique (6) révélant la couche de contact (4).

2. Procédé selon la revendication 1, caractérisé en ce que les étapes d'épitaxie se font par épitaxie par jets moléculaires (MBE) ou par épitaxie par jet chimique (CBE).

3. Procédé selon la revendication 2, caractérisé en ce que la distance substrat (S)-masque (M) est comprise entre 0 et 2 mm.

## Patentansprüche

1. Verfahren zur Herstellung einer optoelektronischen Vorrichtung, die die folgenden Verfahrensschritte aufweist:
- einem Verfahrensschritt, bei dem in einem Epitaxialgehäuse eine Maske (M) oberhalb eines Substrats (S) angebracht wird, auf dem das epitaxiale Wachstum erfolgen soll,
- einem ersten Verfahrensschritt des epitaxialen Wachstums, bei dem auf dem Substrat (S) durch die Maske hindurch verschiedene die optoelektronische Vorrichtung bildende Schichten aufgebracht werden, nämlich
. eine erste optische Einschließungsschicht (1),
. aktive Schichten (2),
. eine zweite optische Einschließungsschicht (3),
. eine Kontaktschicht (4),
. eine Maskenschicht (5),
- einem Verfahrensschritt, bei dem die Maske (M) ohne Öffnen des Epitaxiegehäuses entfernt wird,
- einem zweiten Verfahrensschritt des epitaxialen Wachstums einer optischen und elektrischen Einschließungsschicht (6),
- einem Verfahrensschritt, bei dem die Maskenschicht (5) mit dem Material der optischen und elektrischen Einschließungsschicht (6) entfernt wird und die Kontaktschicht (4) zu Tage tritt.

2. Verfahren nach Anspruch 1, dadurch gekennzeichnet, daß die Verfahrensschritte des epitaxialen Wachstums die Technik der Molekularstrahlepitaxie (MBE) oder der Chemiestrahlepitaxie (CBE) verwenden.

3. Verfahren nach Anspruch 2, dadurch gekennzeichnet, daß der Abstand zwischen dem Substrat (S) und der Maske (M) zwischen O und 2 mm liegt.

## Claims

1. Method of manufacturing an optoelectronic device, which includes the following steps:
- a step of installing, in an epitaxy chamber, a mask (M) above a substrate (S) on which epitaxy is to be performed;
- a first step of epitaxy, on the substrate (S), through the mask, of various layers making up the optoelectronic device:
. first optical confinement layer (1)
. active layers (2)
. second optical confinement layer (3)
. contact layer (4)
. masking layer (5)
- a step of removing the mask (M) without opening the epitaxy chamber;
- a second step of epitaxy of an optical and electrical confinement layer (6);
- a step of removing the masking layer (5) and the material of the optical and electrical confinement layer (6), revealing the contact layer (4).

2. Method according to Claim 1, characterized in that the epitaxy steps are performed by molecular beam epitaxy (MBE) or by chemical beam epitaxy (CBE).

3. Method according to Claim 2, characterized in that the substrate (S)/mask (M) distance lies between 0 and 2 mm.
